# EUROPÄISCHE PATENTSCHRIFT

(11) **EP 1 797 600 B1**
(45) Veröffentlichungstag und Bekanntmachung des Hinweises auf die Patenterteilung: **02.07.2008**
(21) Anmeldenummer: 05794442.3
(22) Anmeldetag: 27.09.2005
(51) Int. Cl.: H01L 39/16

(54) **VORRICHTUNG ZUR STROMBEGRENZUNG VOM RESISTIVEN TYP MIT BANDFÖRMIGEM HOCH-Tc-SUPRALEITER**
DEVICE FOR LIMITING CURRENT OF THE RESISTIVE TYPE WITH A STRIP-SHAPED HIGH Tc SUPERCONDUCTOR
DISPOSITIF DE LIMITATION DU COURANT DE TYPE RESISTIF A SUPRACONDUCTEUR A HAUTE Tc SOUS FORME DE BANDE

(30) Priorität: 04.10.2004 DE 102004048648
(43) Veröffentlichungstag der Anmeldung: 20.06.2007
(73) Patentinhaber: SIEMENS AKTIENGESELLSCHAFT, 80333 München (DE)
(72) Erfinder: KRÄMER, Hans-Peter, 91058 Erlangen (DE); SCHMIDT, Wolfgang, 91056 Erlangen (DE)
(86) Internationale Anmeldenummer: PCT/EP2005/054844
(87) Internationale Veröffentlichungsnummer: WO 2006/037740

(56) Entgegenhaltungen:
- EP-A- 0 315 460
- WO-A-99/33122
- DE-A1- 10 226 391
- DE-A1- 19 909 266
- DE-C1- 4 434 819

## Beschreibung

Die Erfindung bezieht sich auf eine resistive supraleitende Strombegrenzungsvorrichtung mit einer Leiterbahn aus einem bandförmigen Supraleiter, dessen Leiteraufbau zumindest ein Substratband aus einem normalleitenden Substratmetall, eine supraleitende Schicht aus einem oxidischen Hoch-T_{c}-Supraleitermaterial vom AB₂Cu₃Oₓ-Typ mit A zumindest einem Seltenen Erdmetall einschließlich Yttrium und B mindestens einem Erdalkalimetall, eine dazwischen angeordnete Pufferschicht aus einem oxidischen Puffermaterial mit angepassten kristallinen Abmessungen sowie eine auf der supraleitenden Schicht aufgebrachte Deckschicht aus einem normalleitenden Deckschichtmaterial enthält. Eine entsprechende Strombegrenzungsvorrichtung geht aus der DE 199 09 266 A1 hervor. Ein derartige Strombegrenzungsvorrichtung geht auch aus der WO 99/33/22 hervor. Seit 1986 sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und insbesondere eine Flüssig-Stickstoff (LN₂)-Kühltechnik erlauben. Unter solche Metalloxidverbindungen fallen insbesondere Cuprate auf Basis spezieller Stoffsysteme wie z.B. vom Typ AB₂Cu₃Oₓ, wobei A zumindest ein Seltenes Erdmetall einschließlich Yttrium und B mindestens ein Erdalkalimetall sind. Hauptvertreter dieses Stoffsystems vom sogenannten 1-2-3-HTS-Typ ist das sogenannte YBCO (Y₁Ba₂Cu₃Oₓ mit 6,5 ≤ x ≤ 7).

Dieses bekannte HTS-Material versucht man, auf verschiedenen Substraten für unterschiedliche Anwendungszwecke abzuscheiden, wobei im Allgemeinen nach möglichst phasenreinem Supraleitermaterial getrachtet wird. So werden insbesondere metallische Substrate für Leiteranwendungen vorgesehen (vgl. z.B. EP 0 292 959 A1).

Bei einem entsprechenden Leiteraufbau wird das HTS-Material im Allgemeinen nicht unmittelbar auf einem als Substrat dienenden Trägerband abgeschieden; sondern dieses Substratband wird zunächst mit wenigstens einer dünnen Zwischenschicht, die auch als Pufferschicht (bzw. "Buffer"-Schicht) bezeichnet wird, abgedeckt. Diese Pufferschicht mit einer Dicke in der Größenordnung von 1 µm soll einerseits das Eindiffundieren von Metallatomen aus dem Substrat in das HTS-Material verhindern, welche die supraleitenden Eigenschaften verschlechtern könnten. Zum anderen soll die Pufferschicht eine texturierte Ausbildung des HTS-Materials ermöglichen. Entsprechende Pufferschichten bestehen im Allgemeinen aus Oxiden von Metallen wie Zirkon, Cer, Yttrium, Aluminium, Strontium oder Magnesium oder Mischkristallen mit mehreren dieser Metalle und sind somit elektrisch isolierend. In einer entsprechenden stromleitenden Leiterbahn ergibt sich dadurch eine Problematik, sobald das supraleitende Material in den normalleitenden Zustand übergeht (sogenanntes "Quenchen"). Dabei wird der Supraleiter zunächst streckenweise resistiv und nimmt so einen Widerstand R an, z.B. indem er sich über die Sprungtemperatur T_{c} seines Supraleitermaterial erwärmt (in sogenannten "Hot Spots" oder Teilquenchbereichen) und sich meist weiter erhitzt, so dass die Schicht durchbrennen kann.

Auf Grund dieser Problematik ist es bekannt, direkt auf der HTS-Leitungsschicht eine zusätzliche metallische Deckschicht aus einem elektrisch gut leitenden, mit dem HTS-Material verträglichen Material wie Au oder Ag als Shunt gegen ein Durchbrennen aufzubringen. Das HTS-Material steht also in einem elektrisch leitenden, flächenhaften Kontakt mit der metallischen Deckschicht (vgl. DE 44 34 819 C).

Wegen der auch mit Shunts vorhandenen Hot-Spots oder Teilquenchbereiche verteilt sich die Spannung ungleichmäßig längs der Supraleiterschicht. In dem die supraleitende Schicht tragenden Substratband fällt hingegen die an den Enden angelegte Spannung U gleichmäßig über die gesamte Länge ab bzw. es befindet sich auf einem undefinierten Zwischenpotential, falls die Enden von der angelegten Spannung isoliert sind. Die Folge davon können unter Umständen Spannungsdifferenzen von der Leiterbahn über die Pufferschicht zum Substrat sein. Dies führt wegen der geringen Dicke dieser Schicht unvermeidlich zu elektrischen Durchschlägen und so zu punktueller Zerstörung der Pufferschicht und gegebenenfalls der Supraleitungsschicht. Für einen Durchschlag reichen typischerweise Spannungen in der Größenordnung von 20 bis 100 Volt für Pufferschichtdicken von 1 µm aus. Eine entsprechende Problematik ergibt sich insbesondere dann, wenn mit entsprechenden Leiterbändern resistive Strombegrenzungsvorrichtungen erstellt werden sollen. Bei einer solchen Vorrichtung wird nämlich der Übergang vom supraleitenden in den normalleitenden Zustand zur Strombegrenzung im Kurzschlussfall ausgenutzt. Es ist hier nicht ohne weiteres möglich, die Pufferschicht ausreichend spannungsfest für die für solche Einrichtungen üblichen Betriebsspannungen im kV-Bereich zu machen.

Bei der aus der eingangs genannten DE-A1-Schrift zu entnehmenden Strombegrenzungsvorrichtung wird ein bandförmiger Supraleiter mit einem entsprechenden Aufbau verwendet. Bei diesem Aufbau besteht die angesprochene Gefahr von elektrischen Durchschlägen über die Pufferschicht.

Aufgabe der vorliegenden Erfindung ist es, bei einer resistiven supraleitenden Strombegrenzungsvorrichtung mit den eingangs genannten Merkmalen diese Gefahr eines elektrischen Durchschlags bei einem Quenchen im Strombegrenzungsfall auszuschließen.

Diese Aufgabe wird mit den in Anspruch 1 angegebenen Maßnahmen gelöst. Demgemäß soll bei der Strombegrenzungsvorrichtung mit den eingangs genannten Merkmalen die wenigstens eine Pufferschicht derart ausgebildet sein, dass zwischen der supraleitenden Schicht und dem Substratband zumindest in Teilbereichen ein Übergangswiderstand von höchstens 10⁻³ Ω·cm², vorzugsweise von höchstens 10⁻⁵ Ω·cm² ausgebildet ist.

Die Erfindung geht dabei von der Überlegung aus, dass die erwähnte, für Strombegrenzungsvorrichtungen spezifische Problematik sich mit bestimmten Pufferschichtmaterialien lösen lässt. Es wurde erkannt, dass mit der erfindungsgemäßen Bemessung des auf die Flächeneinheit bezogenen Übergangswiderstandes (bei Betriebstemperatur des Supraleitermaterials von etwa 77 K) der angestrebten Potentialausgleich zu gewährleisten ist. Die hier verwendete physikalische Größe "Übergangswiderstand" wird in Ohm. cm² (Ω · cm²) oder in Ohm · m² angegeben. Sie wird vielfach auch als "Kontaktflächenwiderstand" bezeichnet (vgl. z.B. "Applied Physics Letters", Vol. 52, No. 4, 25.01.1988, Seiten 331 bis 333 oder EP 0 315 460 A2). Dieser Übergangswiderstand stellt dabei den elektrischen (Ohm'schen) Widerstand R (gemessen in Ω) einer flächigen Verbindung mit 1 cm² bzw. 1 m² Übertrittsfläche A zwischen zwei insbesondere elektrisch leitenden Teilen dar. Das Produkt R·A ist von der Übertrittsfläche unabhängig. Es kennzeichnet die Güte einer elektrischen flächenhaften Verbindung zwischen zwei verbundenen Teilen wie z.B. bei einer Lötverbindung zwischen zwei Leitern oder bei Kontakten eines Schalters zwischen dessen Kontaktstücken.

Die mit der erfindungsgemäßen Ausbildung der Strombegrenzungsvorrichtung verbundenen Vorteile sind demnach darin zu sehen, dass das metallische Substratband und die normalleitende Deckschicht und damit auch die mit ihr galvanisch verbundene supraleitende Schicht über die wenigstens eine Pufferschicht zumindest in Teilbereichen in gegenseitigen elektrischen Kontakt zu bringen sind und somit auf ein gemeinsames elektrisches Potential auch im Falle eines Quenches zu legen sind. Auf diese Weise wird ein Durchschlag über eine Pufferschicht unterbunden, wie er bei den bekannten Strombegrenzungsvorrichtungen auftreten kann.

Bei der vorgeschlagenen Strombegrenzungsvorrichtung können insbesondere noch folgende Maßnahmen im Einzelnen oder auch in Kombination zusätzlich vorgesehen werden:

So kann für das Material der Pufferschicht bevorzugt ein solches gewählt werden, das einen mittleren spezifischen Widerstand von höchstens 5000 µΩ·cm, vorzugsweise von höchstens 500 µΩ·cm, aufweist.

Wird für das Material der Pufferschicht eine oxidische Verbindung vom Typ La-Mn-O oder Sr-Ru-O oder La-Ni-O oder In-Sn-O gewählt, so ist die erfindungsgemäße Bemessung des Übergangswiderstandes ohne weiteres einzuhalten.

Der Leiteraufbau des Supraleiters ist selbstverständlich nicht auf die genannten vier Schichten oder Lagen beschränkt. So kann man für die Deckschicht und/oder die Pufferschicht jeweils auch ein Schichtensystem aus mehreren Lagen vorsehen.

Weitere vorteilhafte Ausgestaltungen der Strombegrenzungsvorrichtung nach der Erfindung gehen aus den vorstehend nicht angesprochenen Unteransprüchen hervor.

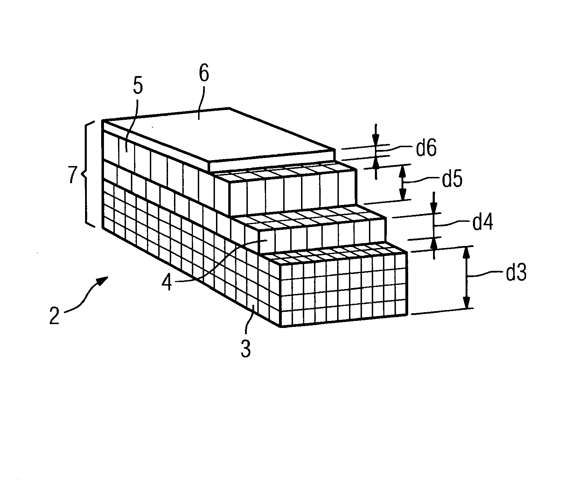

Zur weiteren Erläuterung der Erfindung wird nachfolgend auf die Zeichnung Bezug genommen, an Hand derer ein bevorzugtes Ausführungsbeispiele einer Strombegrenzungsvorrichtungen erläutert ist. Dabei zeigt in stark schematisierter Form deren einzige Figur den Aufbau eines YBCO-Bandleiters der Strombegrenzungsvorrichtung in Schrägansicht.

Bei dem in der Figur angedeuteten, allgemein mit 2 bezeichneten Bandleiter wird von an sich bekannten Ausführungsformen von sogenannten YBCO-Bandleitern oder "YBCO Coated Conductors" ausgegangen. In der Figur sind bezeichnet mit 3 ein Substratband aus einem normalleitenden Substratmetall der Dicke d3,
4 wenigstens eine darauf aufgebrachte Pufferschicht aus einem besonderen oxidischen Puffermaterial der Dicke d4,
5 wenigstens eine HTS-Schicht aus YBCO der Dicke d5,
6 wenigstens eine Deckschicht aus einem normalleitenden Deckmetall der Dicke d6 als eine Schutz- und/oder Kontaktschicht
sowie
7 der Leiteraufbau aus diesen vier Teilen.

Dabei kann man diese Teile wie folgt ausbilden:
- Ein metallisches Substratband 3 aus Ni, Ni-Legierungen oder Edelstahl mit einer Dicke d3 von etwa 50 bis 250 µm,
- wenigstens eine Pufferschicht oder ein Pufferschichtensystem aus einer oder mehreren Lagen von besonders zu wählenden Oxiden mit einer Dicke d4 von etwa 0,1 bis 1, 5µm,
- wenigstens eine HTS-Schicht 5 aus YBCO mit einer-Dicke d5 zwischen etwa 0,3 und 3 µm,
   und
- wenigstens eine metallische Deckschicht 6 aus Ag, Au oder Cu mit einer Dicke d6 zwischen etwa 0,1µm und 1mm. Die Deckschicht kann dabei auch aus mehreren Lagen aus metallischem Material, gegebenenfalls verschiedenen Metallen zusammengesetzt sein.

Ein entsprechender Bandleiter ist einige Millimeter bis wenige Zentimeter breit. Seine supraleitende Stromfähigkeit wird von der YBCO-Schicht 5, d.h. von deren kritischer Stromdichte bestimmt, während die thermischen, mechanischen und normalleitenden Eigenschaften wegen der größeren Dicke d3 von dem Substratband 3 dominiert werden. Dabei bildet das Substratband zusammen mit der Pufferschicht eine Unterlage für ein quasi einkristallines Wachstum des YBCO. Substratbandmaterial und Pufferschichtmaterial dürfen im thermischen Ausdehnungskoeffizienten und in ihren kristallographischen Gitterkonstanten nicht zu weit vom YBCO abweichen. Je besser die Anpassung desto höher ist die rissfreie Schichtdicke und desto besser die Kristallinität des YBCO. Darüber hinaus ist für hohe kritische Stromdichten im MA/cm²-Bereich eine möglichst parallele Ausrichtung der Kristallachsen in benachbarten Kristalliten gewünscht. Dies erfordert eine eben solche Ausrichtung zumindest in der obersten Pufferschicht, damit das YBCO heteroepitaktisch aufwachsen kann. Die Präparation solcher quasi einkristalliner flexibler Substrat-Puffersysteme gelingt bevorzugt mit drei Verfahren:
- Sogenanntes "Ion Beam Assisted Deposition (IBAD)" von meist YSZ oder MgO auf untexturierten Metallbändern,
- sogenannte "Inclined Substrate Deposition (ISD)" von YSZ oder MgO auf untexturierten Metallbändern,
- sogenannte "Rolling Assisted Biaxially Textured Substrates (RABiTS)", d.h. durch Walz- und Glühbehandlung in Würfellage gebrachte Substrate mit heteroepitaktischem Puffersystem.

Die auf dem Substratband abzuscheidenden Funktionsschichten 4 bis 6 werden in an sich bekannter Weise mit Vakummbeschichtungsverfahren (PVD), chemischer Abscheidung aus der Gasphase (CVD) oder aus chemischen Lösungen (CSD) hergestellt.

Selbstverständlich können an der Grenzfläche zwischen den einzelnen Schichten des Aufbaus 7 noch vergleichsweise dünnere, sich bei der Herstellung des Aufbaus bzw. der Abscheidung der einzelnen Schichten insbesondere durch Diffusions- und/oder Reaktionsvorgänge ausbildende Zwischenschichten vorhanden sein.

Im Vergleich zu den für YBCO-Dünnschicht-Strombegrenzungsvorrichtungen bekannten keramischen Plattenleitern ist bei Bandleitern des vorstehend geschilderten Typs das Substratband 3 elektrisch leitfähig, d.h. es kann den begrenzten Strom tragen und als Shunt wirken. Mit dem in der Figur gezeigten Leiteraufbau 7 wären jedoch die HTS-Schicht 5 und das Substratband 3 voneinander isoliert, falls man die für bekannte Strombegrenzungsvorrichtungen üblichen Pufferschichtmaterialien wie CeO₂ oder YSZ wählt. Sobald die Strombegrenzungseinrichtung in ihren begrenzenden Zustand übergeht, d.h. normalleitend wird und sich eine Spannung längs der Leiterbahn aufbaut, wird die Durchschlagsfeldstärke der bekannten Pufferschichtmaterialien, die in der Größenordnung von 100 kV/mm = 10 V/0,1 µm liegen, schnell überschritten. D.h., die Pufferschicht 4 würde dann unkontrolliert durchschlagen. Daher ist erfindungsgemäß ein besonders auszuwählendes Pufferschichtmaterial für den Einsatz von YBCO-Bandleitern in Strombegrenzungsvorrichtungen vorteilhaft. Dabei müssen selbstverständlich auch die vorstehend angesprochenen Gesichtspunkte einer hinreichenden Anpassung der kristallinen Abmessungen des verwendeten HTS-Materials und des Pufferschichtmaterials berücksichtigt werden.

Unter dem weiteren Gesichtspunkt eines Potentialausgleichs zwischen supraleitender Schicht 5 und damit auch Deckschicht 6 einerseits und dem Substratband 3 andererseits wird für die wenigstens eine Pufferschicht 4 ein solches oxidisches Material gewählt, dass zwischen der supraleitenden Schicht 5 und dem Substratband 3 ein Übergangswiderstand zumindest an einzelnen beispielsweise inselartigen Stellen, vorzugsweise über die gesamte gemeinsame Flächenausdehnung von höchstens 10⁻³ Ω·cm², vorzugsweise von höchstens 10⁻⁵ Ω·cm² ausgebildet ist. Unter Einhaltung dieser Werte ist dann der gewünschte Potentialausgleich zu realisieren.

Insbesondere kann man für die Pufferschicht 4 ein Material wählen, das einen mittleren spezifischen Widerstand von höchstens 5000 µΩ·cm, vorzugsweise von höchstens 500 µΩ·cm, aufweist. Es hat sich nämlich gezeigt, dass mit oxidischen Materialien, die dieser Bedingung genügen, die vorstehend genannten Übergangswiderstände zu erreichen sind und damit der gewünschte Potentialausgleich ermöglicht wird.

Beispiele für Materialien, die alle genannten Voraussetzungen erfüllen, sind an sich bekannte oxidische Materialien vom Typ La-Mn-O oder Sr-Ru-O oder La-Ni-O oder In-Sn-O (das sogenannte "ITO").

Bei dem vorstehenden Ausführungsbeispiel wurde YBCO als HTS-Material für die supraleitende Schicht 5 zugrunde gelegt. Selbstverständlich sind auch andere HTS-Materialien vom sogenannten 1-2-3-Typ mit anderen Seltenen Erdmetallen und/oder anderen Erdalkalimetallen einsetzbar. Die einzelnen Komponenten dieser Materialien können auch in an sich bekannter Weise teilweise durch weitere/andere Komponenten substituiert sein.

## Patentansprüche

1. Resistive supraleitende Strombegrenzungsvorrichtung mit einer Leiterbahn (2) aus einem bandförmigen Supraleiter, dessen Leiteraufbau (7) zumindest
- ein Substratband (3) aus einem normalleitenden Substratmetall,
- eine supraleitende Schicht (5) aus einem oxidischen Hoch-T_{c}-Supraleitermaterial vom AB₂Cu₃Oₓ-Typ mit A für mindestens ein Seltenes Erdmetall einschließlich Yttrium und B für mindestens ein Erdalkalimetall,
- eine dazwischen angeordnete Pufferschicht (4) aus einem oxidischen Puffermaterial mit angepassten kristallinen Abmessungen
sowie
- eine auf der supraleitenden Schicht (5) aufgebrachte Deckschicht (6) aus einem normalleitenden Deckschichtmaterial enthält, **dadurch gekennzeichnet, dass** die wenigstens eine Pufferschicht (4) derart ausgebildet, dass zwischen der supraleitenden Schicht (5) und dem Substratband (3) zumindest in Teilbereichen ein Übergangswiderstand von höchstens 10⁻³ Ω·cm² ausgebildet ist.

2. Strombegrenzungsvorrichtung nach Anspruch 1, **dadurch gekennzeichnet, dass** zwischen der supraleitenden Schicht (5) und dem Substratband (3) zumindest in Teilbereichen ein Übergangswiderstand von höchstens 10⁻⁵ Ω·cm² ausgebildet ist.

3. Strombegrenzungsvorrichtung nach Anspruch 1 oder 2, **dadurch gekennzeichnet, dass** für das Material der Pufferschicht (4) ein solches wählt, das einen mittleren spezifischen Widerstand von höchstens 5000 µΩ·cm, vorzugsweise von höchstens 500 µΩ·cm, aufweist.

4. Strombegrenzungsvorrichtung nach einem der vorangehenden Ansprüche, **dadurch gekennzeichnet, dass** für das Material der Pufferschicht (4) ein oxidisches Material vom Typ La-Mn-O oder Sr-Ru-O oder La-Ni-O oder In-Sn-O gewählt ist.

5. Strombegrenzungsvorrichtung nach einem der vorangehenden Ansprüche, **dadurch gekennzeichnet, dass** die Deckschicht (6) aus mehreren Lagen aus metallischem Material zusammengesetzt ist.

6. Strombegrenzungsvorrichtung nach einem der vorangehenden Ansprüche, **dadurch gekennzeichnet, dass** die Pufferschicht (4) aus mehreren Lagen aus verschiedenen oxidischen Materialien zusammengesetzt ist.

## Claims

1. Resistive superconducting current-limiting apparatus with a conductor track (2) composed of a superconductor in the form of a strip, whose conductor structure (7) contains at least
- a substrate strip (3) composed of a normally conductive substrate metal,
- a superconducting layer (5) composed of an oxidic high-T_{c} superconductor material of the AB₂Cu₃Oₓ type where A represents at least one rare earth metal including yttrium, and B represents at least one alkaline earth metal,
- a buffer layer (4), which is arranged between them and is composed of an oxidic buffer material with matched crystalline dimensions,
as well as
- a covering layer (6) which is applied to the superconducting layer (5) and is composed of a normally conductive covering layer material,
**characterized in that** the at least one buffer layer (4) is formed in such a manner that a contact resistance of at most 10⁻³ Ω·cm² is formed, at least in subareas, between the superconducting layer (5) and the substrate strip (3).

2. Current-limiting apparatus according to Claim 1, **characterized in that** a contact resistance of at most 10⁻⁵ Ω·cm² is formed, at least in subareas, between the superconducting layer (5) and the substrate strip (3).

3. Current-limiting apparatus according to Claim 1 or 2, **characterized in that** a material which has a mean resistivity of at most 5000 µΩ·cm, preferably of at most 500 µΩ·cm, is chosen for the material of the buffer layer (4).

4. Current-limiting apparatus according to one of the preceding Claims, **characterized in that** an oxidic material of the La-Mn-O, Sr-Ru-O, La-Ni-O or In-Sn-O type is chosen for the material of the buffer layer (4).

5. Current-limiting apparatus according to one of the preceding Claims, **characterized in that** the covering layer (6) is composed of a plurality of layers of metallic material.

6. Current limiting apparatus according to one of the preceding Claims, **characterized in that** the buffer layer (4) is composed of a plurality of layers of different oxidic materials.

## Revendications

1. Dispositif résistif supraconducteur de limitation du courant, comprenant une piste (2) conductrice en un supraconducteur en forme de ruban dont la structure (7) de conducteur comporte au moins
- un ruban (3) de substrat en un métal de substrat normalement conducteur ;
- une couche (5) supraconductrice en un matériau supraconducteur oxydé à T_{c} haute du type AB₂CU₃Oₓ, A représentant au moins un métal de terres rares, y compris l'yttrium, et B au moins un métal alcalino-terreux ;
- une couche (4) tampon interposée entre eux en un matériau tampon oxydé ayant des dimensions cristallines adaptées ; ainsi que
- une couche (6) de finition, déposée sur la couche (5) supraconductrice et en un matériau de couche de finition normalement conducteur, **caractérisé en ce que** la au moins une couche (4) tampon est telle qu'il est formé au moins dans des régions partielles une résistance de contact au plus de 10⁻³ Ω•cm² entre la couche (5) supraconductrice et le ruban (3) de substrat.

2. Dispositif de limitation du courant suivant la revendication 1, **caractérisé en ce qu'**il est formé au moins dans des régions partielles une résistance de contact au plus de 10⁻⁵ Ω • cm² entre la couche (5) supraconductrice et le ruban (3) de substrat.

3. Dispositif de limitation du courant suivant la revendication 1 ou 2, **caractérisé en ce que** l'on choisit pour le matériau de la couche (4) tampon un matériau tel qu'il ait une résistance spécifique moyenne d'au plus 5 000 µΩ·cm, de préférence d'au plus 5 00 µΩ•cm.

4. Dispositif de limitation du courant suivant l'une des revendications précédentes, **caractérisé en ce que** l'on choisit pour le matériau de la couche (4) tampon un matériau oxydé du type La-Mn-O ou Sr-Ru-O ou La-Ni-0 ou In-Sn-O.

5. Dispositif de limitation du courant suivant l'une des revendications précédentes, **caractérisé en ce que** la couche (6) de finition est composée de plusieurs strates de matériau métallique.

6. Dispositif de limitation du courant suivant l'une des revendications précédentes, **caractérisé en ce que** la couche (4) tampon est composée de plusieurs strates de divers matériaux oxydés.
